# EUROPEAN PATENT APPLICATION

(11) **EP 0 980 098 A1**
(43) Date of publication of application: **16.02.2000**
(21) Application number: 98830500.9
(22) Date of filing: 11.08.1998
(51) Int. Cl.: H01L 23/544, B28D 5/00, B44B 7/00

(54) **Semiconducting material substrate for use in integrated circuits manufacturing processes and production method thereof**

(71) Applicant: STMicroelectronics S.r.l., 20041 Agrate Brianza (Milano) (IT)
(72) Inventor: Pio, Federico, 20047 Brugherio (MI) (IT)
(74) Representative: Dini, Roberto, Dr. Ing.

(57) **Abstract**

A semiconducting material substrate for use in integrated circuits manufacturing processes, where said substrate has a discoidal shape with two surfaces, i.e. a bottom surface and a top surface, respectively, and said substrate is also provided with marking indicia to indicate its crystallographic orientation. According to the present invention discoidal surfaces (2, 3; 12, 13) of said substrate (1; 11) have an axial symmetry and marking indicia (4, 5; 14) are executed at least on one of said discoidal surfaces (2, 3; 12, 13).

## Description

The present invention concerns a semiconducting material substrate for use in integrated circuits manufacturing processes, where said substrate has a discoidal shape with two surfaces, i.e. a bottom surface and a top surface, respectively, and said substrate is also provided with marking indicia to indicate its crystallographic orientation.

Semiconducting material substrates, so-called 'wafers', are currently manufactured by first growing a monocrystal from molten, i.e. from a molten material, for instance according to the Czochralski method. Said monocrystal, i.e. an ingot that will substantially take a cylindrical shape already during this process step, is subsequently turned to give the monocrystal section a circular shape and also milled on one side to mark its crystallographic orientation, usually 〈100〉 or eventually 〈111〉 orientation for silicon. Individual substrates are then obtained by sawing the monocrystal perpendicularly to its main axis. Thus, substrates take a discoidal shape with substantially circular surfaces, save for the milled side identifying its crystallographic orientation, which is flat and is therefore called a 'flat'. Usually, there are two 'flats', a larger one called primary flat and a smaller one called secondary flat, which are arranged at different angles to identify not only the crystallographic orientation but also whether the substrate is a p-type or n-type semiconductor.

'Flats' are specifically useful during the subsequent substrates manufacturing steps because they provide a reference on automated handling machines for substrates orientation in a reliable way. For instance, this appears to be quite useful with respect to chemical etching or when an initial coarse alignment is carried out during process masks aligning operations.

However, the presence of 'flats' on silicon substrates generates some drawbacks when processes have to be applied for a substrate, which require a high degree of axial symmetry with respect to the main substrate axis, i.e. due to its discoidal shape, the axis goes through the disk centre and is normal for the main surfaces. For instance, according to a manufacturing technology for integrated circuits a process step known as 'Chemical Mechanical Polishing' is increasingly applied, which is a chemical-mechanical polishing process used to level the surface of a silicon substrate, typically after some steps implying deposition of dielectric layers on unlevelled types and prior to other process steps requiring a high levelling degree, such as eg. the step for contacts definition and insertion or the step for deposition and definition of a metallic layer for interconnections. The latter is increasingly used in CMOS technologies, where an ever increasing number of layers for interconnections is requested.

Such a dissymmetry introduced by 'flats' in the silicon substrate surface causes thickness irregularity of the residual dielectric after the levelling process. This irregularity is mainly originated by a substrate unbalance during the mechanical polishing action due to introduction of 'flats'. Even in the case of a uniform thickness of such a dielectric locally, the amount of irregularity evaluated across the whole substrate may reach tens to hundreds nanometers. Said irregularity will entail a non-homogeneous electric behaviour of specifically sensitive circuits, eg. parasitic capacities of interconnections or lack of homegeneity during subsequent chemical etching processes, where the chemical etching solution stays on the substrate over the time dictated by the etch rate.

A further drawback in the use of 'flats' is represented by a subtraction of usable area caused by said 'flats'from integrated circuits.

Specifically in the frame of more advanced technologies and for wafers with a diameter over 200 mm, circular substrates with a small size notch on their perimetral edge are used to avoid such a drawback. The shape of said notch, whose use for alignment purposes is quite similar to the one adopted for 'flats', may sometimes cause a cracking of the wafer, especially when the latter is submitted to thermal and mechanical stresses.

It is the object of the present invention to solve the above drawbacks and provide a semiconducting material substrate, having a more efficient and improved performance.

In this frame, it is the main object of the present invention to provide a semiconducting material substrate compatible with manufacturing processes demanding a high symmetry degree of the substrate.

A further object of the present invention is to provide a semiconducting material substrate with marking indicia representative of orientation information and doping type of the substrate to allow automatic alignment of the substrate itself.

A further object of the present invention is to provide a semiconducting material substrate having an increased usable surface.

In order to achieve such aims, it is the object of the present invention to provide a semiconducting material substrate and/or a manufacturing method of semiconducting material substrates and/or an identifying method of the crystallographic orientation and geometric orientation of semiconducting material substrates incorporating the features of the annexed claims, which form an integral part of the description herein.

Further objects, features and advantages of the present invention will become apparent from the following detailed description and annexed drawings, which are supplied by way of non limiting example, wherein:
- Fig. 1 shows a plan view of a semiconducting material substrate according to the present invention;
- Fig. 2 shows schematically a different embodiment of the semiconducting material substrate of figure 1;
- Fig. 3 shows a partial view of the semiconducting material substrate of figure 2;
- Fig. 4 shows schematically a second different embodiment of the semiconducting material substrate of figure 1.

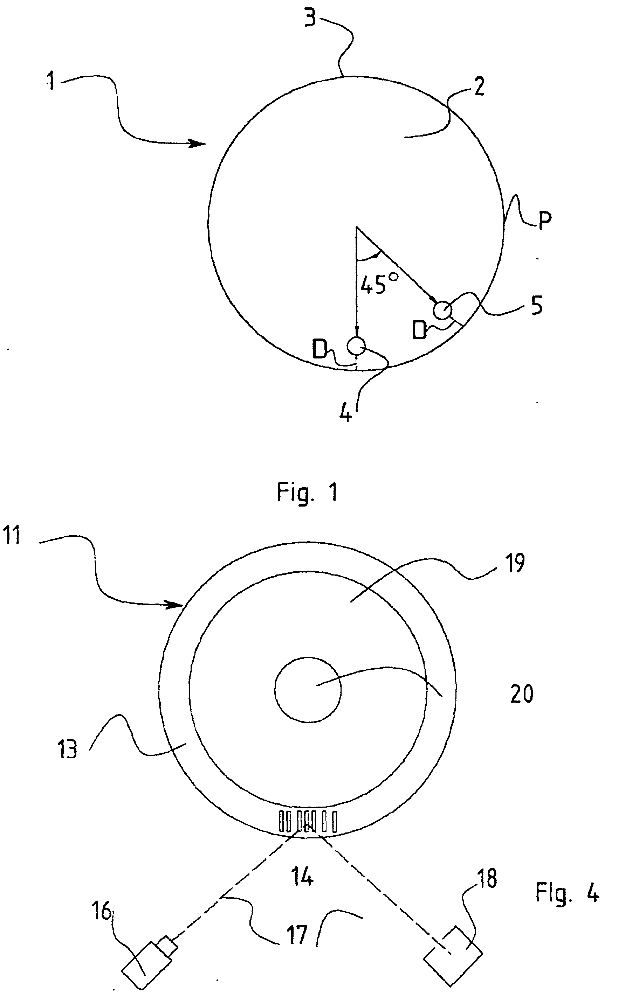

Figure 1 shows a silicon substrate 1 according to the present invention, where said silicon substrate 1 is represented by a plan view of its top surface 2. Said top surface 2 has a perfectly circular shape, free of 'flats'. Said top surface 2 has a first small circular hole 4 obtained by drilling the silicon substrate 1. Said first hole 4 is a through hole, i.e. also pasing through a bottom surface 2 of the silicon substrate 1, not illustrated in Fig. 1. Dimensions of the first hole 4 range from 0.5 to 1 mm. Said first hole 4 is located at a fixed distance D from a perimeter P of the silicon substrate 1, which may range from 3 to 6 mm. Said first hole 4 is placed in correspondence with the point where the primary 'flat' should be located.

Then a second hole 5 is pierced at an angle of 45° from the first hole 4, said second hole 5 having the same size and same fixed distance D from the perimeter P. The second hole 5 replaces the 'secondary flat'; thus, according to the convention in force, the first hole 4 and the second hole 5 will identify the silicon substrate 1 as an n-type substrate with orientation 〈111〉.

Obviously, to identify both the type and orientation of the substrate the angle between the first hole 4 and second hole 5 may differ of 90° or 180°, or the second hole 4 may not be available.

Similarly, the dimensions of the second hole 5 and the fixed distance D from the perimeter P may differ from the ones pertaining to the first hole 4.

Thus, it is clear that the circular symmetry of surfaces 2 and 3 of the silicon substrate 1 will obviate to the drawbacks in those processes requiring a high axial symmetry in the substrates.

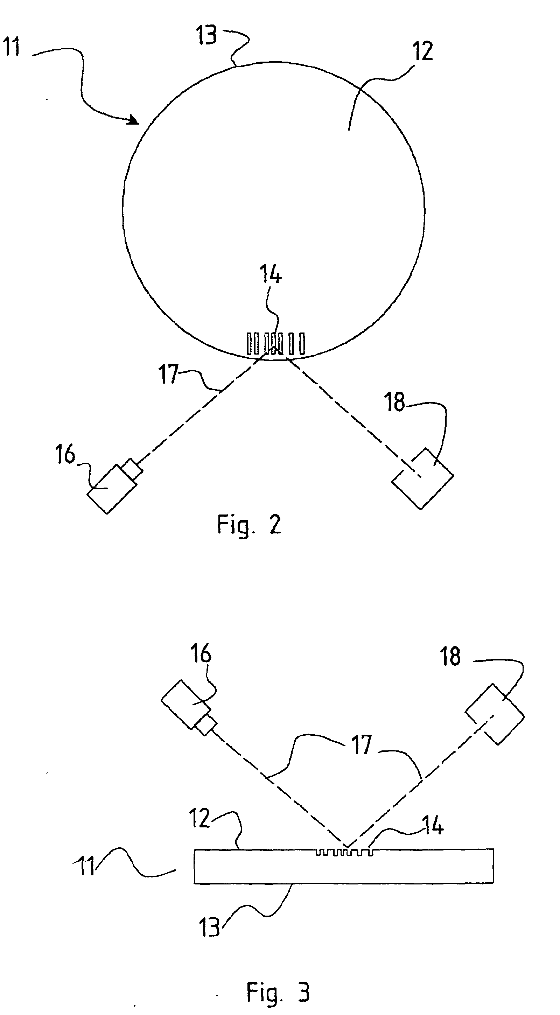

The first hole 4 and the second hole 5 contain information on substrate orientation and type, which can be read by automated machines through a simple optical laser-photodetector reading system, similar to the one further illustrated with reference to figs. 2, 3, 4.

The following steps are required for the manufacturing process of the silicon substrate 1:
- drawing the monocrystal from molten material and turning it;
- sawing said monocrystal in a plurality of substrates 1;
- piercing said substrates 1, eg., performing a drilling operation to make the first hole 4 and eventually the second hole 5.

Figure 2 shows a plan view of a silicon substrate 11 with the same shape as the silicon substrate 1 of fig. 1, which bears some markings 14 in the form of a bar code on its top surface 12. Said markings 14, as better visible in the side section of the silicon substrate 11 represented in fig. 3, are obtained by engraving the top surface 12 with the use of a high power laser causing local sublimation of the semiconductor. This technique is similar to the technique used to write anagraphic information related to the substrate, allowing trackingof each substrate during manufacturing and test steps. Markings 14 are 1 or 2 µm deep. They are eg. perpendicular to a crystalline plane, as usually done for the primary 'flat'.

The following steps are required for the manufacturing process of the silicon substrate 11:
- drawing the monocrystal from molten material and turning it;
- sawing said monocrystal in a plurality of substrates 1;
- engraving said substrates 1 using a high power laser to obtain markings 14 on the top surface 12 of the silicon substrate 11.

On the other hand, said engraving operation to obtain markings 14 can be carried out prior to the sawing step. In other words, the monocrystal is first engraved and the substrate 11 subsequently sawn. Then a new engravng operation takes place on the monocrystal surface and a further substrate 11 will be sawn. In this case it is advisable to have markings 14 deep enough to stay on in spite of subsequent polishing operations on the surfaces of the silicon substrate 11.

In figure 3 also a laser 16 emitting a beam 17 picked up by a photodetector 18 can be seen, said photodetector collecting the light reflected from the not engraved area of the top surface 12 and the light spreading out from the markings 14 and allowing automatic identification of both the orientation and type of substrate through optical reading. In a likely embodiment said markings 14 representing the bar code may be arranged radially to the centre of the top surface 12; thus, the beam 17 will strike at constant time intervals each marking 14, provided the rotary speed of the substrate 11 is regular. The laser 16 and the photodetector 18 can also be used in conjunction with the first hole 4 and the second hole 5 of the substrate 1 of figure 1. In this case the photodetector 18 will receive the beam 17 transmitted through the silicon substrate 11, and not the reflected beam 17.

In a preferred embodiment of the present invention markings 14 are executed over a bottom surface 13 of the silicon substrate 11, as it can be seen in figure 4. Here, the silicon substrate 11 is represented on a support 19 revolving on a shaft 20. The diameter of the support 19 is smaller than the diameter of the silicon substrate 11, so that reading the code reported in markings 14 will be easy through the laser 16 and the photodetector 18.

According to the above description the features of the present invention as well as its advantages will be quite clear.

The semiconducting material substrate according to the present invention has advantageously a circular symmetric shape, so that the processes influenced by any dissymetries in the substrate shape, such as CPM mechanical-chemical polishing processes, may be fully efficient.

Moreover, the semiconducting material substrate according to the present invention, though deprived of conventional 'flats', has advantageous marking indicia capable of identifying both the crystallographic orientation and conduction mode proper of the substrate.

The use of bar code markings across the substrate surface allows an efficient coding of the information contained on the silicon substrate. Said information can then be read with the use of simple safe performing optical means. In particular, the advantageous application of markings on the bottom surface of the substrate, i.e. the surface not bearing any integrated circuits, allows to save a useful surface for said circuits and increment the circuits ratio each wafer, with a resulting cost reduction. Engraving the bar codes before sawing the wafers from the monocrystal may prove advantageous since it does not require likely further recognition processes for the geometric orientation of the sawn wafer to proceed to the engraving operation.

It is obvious that many changes are possible for the man skilled in the art to the semiconducting material substrate described above by way of example, without departing from the novelty spirit of the innovative idea, and it is also clear that in practical actuation of the invention the components may often differ in form and size from the ones described and be replaced with technical equivalent elements.

The substrates indicated by way of example are cristalline silicon substrates, but in general they may also consist of gallium arsenide or indium phosphide or other semiconducting materials used to manufacture solid state integrated circuits and devices.

The holes in the substrate can be pierced not only by mechanical drilling, but also with the use of a high power laser.

A likely embodiment can have bar coded markings which may also contain identifying information of the individual substrate for identification and marking during manufacturing process steps.

## Claims

1. A semiconducting material substrate for use in integrated circuits manufacturing processes, where said substrate has a discoidal shape with two surfaces, i.e. a bottom surface and a top surface, respectively, and said substrate is also provided with marking indicia to indicate its crystallographic orientation, characterized in that the discoidal surfaces (2, 3; 12, 13) of said substrate (1; 11) have an axial symmetry and that marking indicia (4, 5; 14) are executed at least on one of said discoidal surfaces (2, 3; 12, 13).

2. A semiconducting material substrate according to claim 1, characterized in that said marking indicia (4, 5; 14) comprise a first hole (4) pierced in the substrate (1).

3. A semiconducting material substrate according to claim 2, characterized in that said marking indicia (4, 5; 14) comprise a second hole (5) pierced in the substrate (1) and arranged at an angle differing from the first hole (4) on the substrate (1).

4. A semiconducting material substrate according to claim 1, characterized in that said marking indicia (4, 5; 14) are obtained by markings on one of the discoidal surfaces (12, 13) of the substrate (11).

5. A semiconducting material substrate according to claim 4, characterized in that said markings (14) are made on the bottom surface (13) of the substrate (11).

6. A semiconducting material substrate according to claim 4 or 5, characterized in that said markings (14) represent a bar code.

7. A semiconducting material substrate according to claim 6, characterized in that the bars of said bar code are arranged radially to the surface centre (12, 13) of the substrate (11).

8. A semiconducting material substrate according to claim 1, characterized in that the discoidal surfaces (2, 3; 12, 13) of said substrate (1; 11) have a circular shape.

9. A manufacturing method for semiconducting material substrates bearing information at least about their crystallographic orientation, comprising an application step of said information on the substrate and a sawing step of said substrate from a cylindrical ingot of semiconducting material, characterized in that said information applying step provides application of marking indicia (4, 5; 14) at least on one of the discoidal surfaces (2, 3; 12, 13) of said substrate (1; 11).

10. A manufacturing method for semiconducting material substrates bearing information at least about their crystallographic orientation, according to claim 8, characterized in that said information applying step is subsequent to the sawing step of the substrates (1, 11) from the cylindrical ingot of semiconducting material

11. A manufacturing method for semiconducting material substrates bearing information at least about their crystallographic orientation, according to claim 10, characterized in that the information applying step consists of a piercing step of the substrate (1), specifically a drilling operation.

12. A manufacturing method for semiconducting material substrates bearing information at least about their crystallographic orientation, according to claim 10, characterized in that said information applying step consists of a laser engraving step of one of the discoidal surfaces (12, 13) of the substrate (11).

13. A manufacturing method for semiconducting material substrates bearing information at least about their crystallographic orientation, according to claim 9, characterized in that the information applying step consists of a laser engraving step of one of the discoidal surfaces (12, 13) of the substrate (11) and is executed prior to the sawing step of said substrates (11) from the cylindrical ingot of semiconducting material.

14. A manufacturing method for semiconducting material substrates bearing information at least about their crystallographic orientation, according to claim 12, characterized in that the information applying step consists of a laser engraving step of the bottom surface (12, 13) of the substrate (11).

15. An identification method at least of the crystallographic orientation and/or geometric orientation of semiconducting material substrates, as provided to use associated information through mechanical modification of the shape of said substrates, characterized in that it provides an optical reading step of information (14) applied to one of the discoidal surfaces (2, 3; 12, 13) of said substrate (1; 11).

16. An identification method of the crystallographic orientation and/or geometric orientation of semiconducting material substrates, according to claim 15, characterized in that said optical reading provides to have a light beam (17) originated from a light source (18) inciding on the means containing information (14) and collect the light beam (17) either reflected or transmitted through a photodetector (18).

17. An identification method of the crystallographic orientation and/or geometric orientation of semiconducting material substrates, according to claim 16, characterized in that said optical reading step is executed with the substrate (11) supported by a support (19) whose diameter is smaller than the diameter of the substrate (11) and the means containing information (14) are located on a bottom surface (13) of said substrate (11).

18. An identification method of the crystallographic orientation and/or geometric orientation of semiconducting material substrates, according to claim 16 or 17, characterized in that said means containing information (14) are in the form of markings representing a bar code.
